# EUROPEAN PATENT APPLICATION

(11) **EP 2 375 314 A1**
(43) Date of publication of application: **12.10.2011**
(21) Application number: 10159405.9
(22) Date of filing: 08.04.2010
(51) Int. Cl.: G06F 3/041

(54) **Touch-sensitive device and method of control**

(71) Applicant: Research in Motion Limited, Waterloo, Ontario N2L 3W8 (CA)
(72) Inventor: Griffin, Jason Tyler, Waterloo Ontario N2L 3W8 (CA); Faubert, Perry Allan, Surrey British Columbia V3S 9J1 (CA)
(74) Representative: Fennell, Gareth Charles

(57) **Abstract**

A method includes identifying a value of at least one parameter of a portable electronic device. A touch threshold is modified based on the value of the at least one parameter, yielding a modified touch threshold. A touch is detected on a touch-sensitive device and a first function is performed when the touch meets the modified touch threshold.

## Description

### Field of Technology

The present disclosure relates to electronic devices, including but not limited to, portable electronic devices having touch-sensitive devices and their control.

### Background

Electronic devices, including portable electronic devices, have gained widespread use and may provide a variety of functions including, for example, telephonic, electronic messaging and other personal information manager (PIM) application functions. Portable electronic devices include, for example, several types of mobile stations such as simple cellular telephones, smart telephones, wireless personal digital assistants (PDAs), and laptop computers with wireless 802.11 or Bluetooth capabilities.

Portable electronic devices such as PDAs or smart telephones are generally intended for handheld use and ease of portability. Smaller devices are generally desirable for portability. A touch-sensitive display, also known as a touchscreen display, is particularly useful on handheld devices, which are small and have limited space for user input and output. The information displayed on the touch-sensitive displays may be modified depending on the functions and operations being performed. With continued demand for decreased size of portable electronic devices, touch-sensitive displays continue to decrease in size.

Improvements in devices with touch-sensitive devices are desirable.

### Brief Description of the Drawings

FIG. 1 is a block diagram of a portable electronic device in accordance with the disclosure.

FIG. 2 is a sectional side view of a portable electronic device with piezoelectric actuators in accordance with the disclosure.

FIG. 3 is a sectional side view of a portable electronic device with a depressed touch-sensitive display in accordance with the disclosure.

FIG. 4 is a sectional side view of a piezoelectric actuator in accordance with the disclosure.

FIG. 5 is a sectional side view of a piezoelectric actuator with a force sensor in accordance with the disclosure.

FIG. 6 is a front view of a portable electronic device having a touch-sensitive display in accordance with the disclosure.

FIG. 7 is a flowchart illustrating a method of modifying a touch threshold in accordance with the disclosure.

FIG. 8 is a graph illustrating various values of a touch threshold over time in accordance with the disclosure.

FIG. 9 is a graph illustrating various values of two touch thresholds over time in accordance with the disclosure.

### Detailed Description

The following describes an apparatus for and method of modifying a touch threshold. Values of one or more parameters may be utilized to modify one or more touch thresholds. The touch threshold(s) may be used, for example, to trigger performance of functions, such as provision of tactile feedback.

For simplicity and clarity of illustration, reference numerals may be repeated among the figures to indicate corresponding or analogous elements. Numerous details are set forth to provide an understanding of the embodiments described herein. The embodiments may be practiced without these details. In other instances, well-known methods, procedures, and components have not been described in detail to avoid obscuring the embodiments described. The description is not to be considered as limited to the scope of the embodiments described herein.

The disclosure generally relates to an electronic device, which is a portable electronic device in the embodiments described herein. Examples of portable electronic devices include mobile, or handheld, wireless communication devices such as pagers, cellular phones, cellular smart-phones, wireless organizers, personal digital assistants, wirelessly enabled notebook computers, and so forth. The portable electronic device may also be a portable electronic device without wireless communication capabilities, such as a handheld electronic game device, digital photograph album, digital camera, or other device.

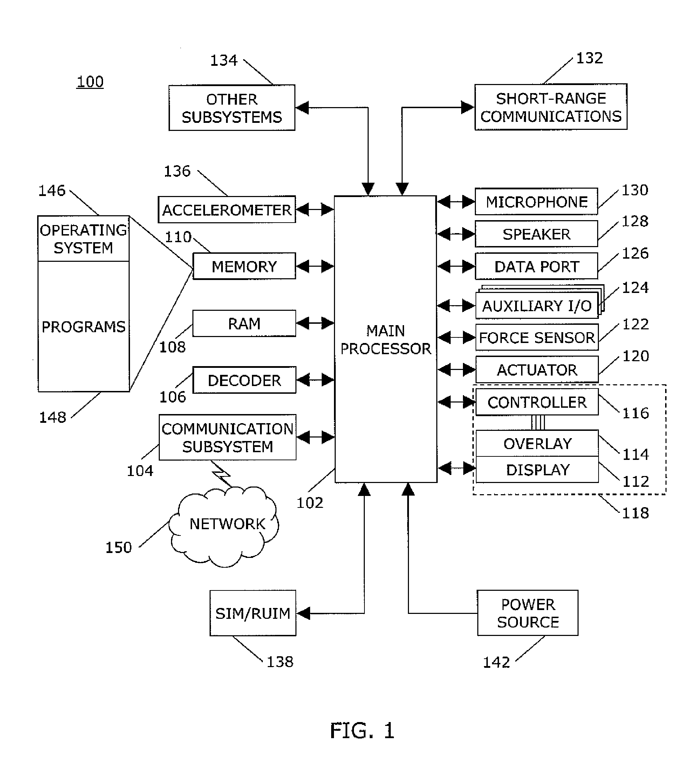

A block diagram of an example of a portable electronic device 100 is shown in FIG. 1. The portable electronic device 100 includes multiple components, such as a processor 102 that controls the overall operation of the portable electronic device 100. Communication functions, including data and voice communications, are performed through a communication subsystem 104. Data received by the portable electronic device 100 is decompressed and decrypted by a decoder 106. The communication subsystem 104 receives messages from and sends messages to a wireless network 150. The wireless network 150 may be any type of wireless network, including, but not limited to, data wireless networks, voice wireless networks, and networks that support both voice and data communications. A power source 142, such as one or more rechargeable batteries or a port to an external power supply, powers the portable electronic device 100.

The processor 102 interacts with other components, such as Random Access Memory (RAM) 108, memory 110, a display 112 with a touch-sensitive overlay 114 operably connected to an electronic controller 116 that together comprise a touch-sensitive display 118, one or more actuators 120, one or more force sensors 122, an auxiliary input/output (I/O) subsystem 124, a data port 126, a speaker 128, a microphone 130, short-range communications 132, and other device subsystems 134. User-interaction with a graphical user interface is performed through the touch-sensitive overlay 114. The processor 102 interacts with the touch-sensitive overlay 114 via the electronic controller 116. Information, such as text, characters, symbols, images, icons, and other items that may be displayed or rendered on a portable electronic device, is displayed on the touch-sensitive display 118 via the processor 102. The processor 102 may interact with an accelerometer 136 that may be utilized to detect direction of gravitational forces or gravity-induced reaction forces.

To identify a subscriber for network access, the portable electronic device 100 uses a Subscriber Identity Module or a Removable User Identity Module (SIM/RUIM) card 138 for communication with a network, such as the wireless network 150. Alternatively, user identification information may be programmed into memory 110.

The portable electronic device 100 includes an operating system 146 and software programs or components 148 that are executed by the processor 102 and are typically stored in a persistent, updatable store such as the memory 110. Additional applications or programs may be loaded onto the portable electronic device 100 through the wireless network 150, the auxiliary I/O subsystem 124, the data port 126, the short-range communications subsystem 132, or any other suitable subsystem 134.

A received signal such as a text message, an e-mail message, or web page download is processed by the communication subsystem 104 and input to the processor 102. The processor 102 processes the received signal for output to the display 112 and/or to the auxiliary I/O subsystem 124. A subscriber may generate data items, for example e-mail messages, which may be transmitted over the wireless network 150 through the communication subsystem 104. For voice communications, the overall operation of the portable electronic device 100 is similar. The speaker 128 outputs audible information converted from electrical signals, and the microphone 130 converts audible information into electrical signals for processing.

The touch-sensitive display 118 may be any suitable touch-sensitive display, such as a capacitive, resistive, infrared, surface acoustic wave (SAW) touch-sensitive display, strain gauge, optical imaging, dispersive signal technology, acoustic pulse recognition, and so forth, as known in the art. A capacitive touch-sensitive display includes a capacitive touch-sensitive overlay 114. The overlay 114 may be an assembly of multiple layers in a stack including, for example, a substrate, a ground shield layer, a barrier layer, one or more capacitive touch sensor layers separated by a substrate or other barrier, and a cover. The capacitive touch sensor layers may be any suitable material, such as patterned indium tin oxide (ITO).

One or more touches, also known as touch contacts or touch functions, may be detected by the touch-sensitive display 118. The processor 102 may determine attributes of the touch, including a location of a touch. Touch location data may include an area of contact or a single point of contact, such as a point at or near a center of the area of contact. A signal is provided to the controller 116 in response to detection of a touch. A touch may be detected from any suitable object, such as a finger, thumb, appendage, or other items, for example, a stylus, pen, or other pointer, depending on the nature of the touch-sensitive display 118. The controller 116 and/or the processor 102 may detect a touch by any suitable contact member on the touch-sensitive display 118. Multiple simultaneous touches may be detected.

The actuator(s) 120 may be depressed by applying sufficient force to the touch-sensitive display 118 to overcome the actuation force of the actuator 120. The actuator 120 may be actuated by pressing anywhere on the touch-sensitive display 118. The actuator 120 may provide input to the processor 102 when actuated. Actuation of the actuator 120 may result in provision of tactile feedback. Various different types of actuators 120 may be utilized, including, for example, piezoelectric actuators, dome-type switches, hydraulic actuators, electromechanical actuators, and so forth. When force is applied, the touch-sensitive display 118 is depressible, pivotable, and/or movable.

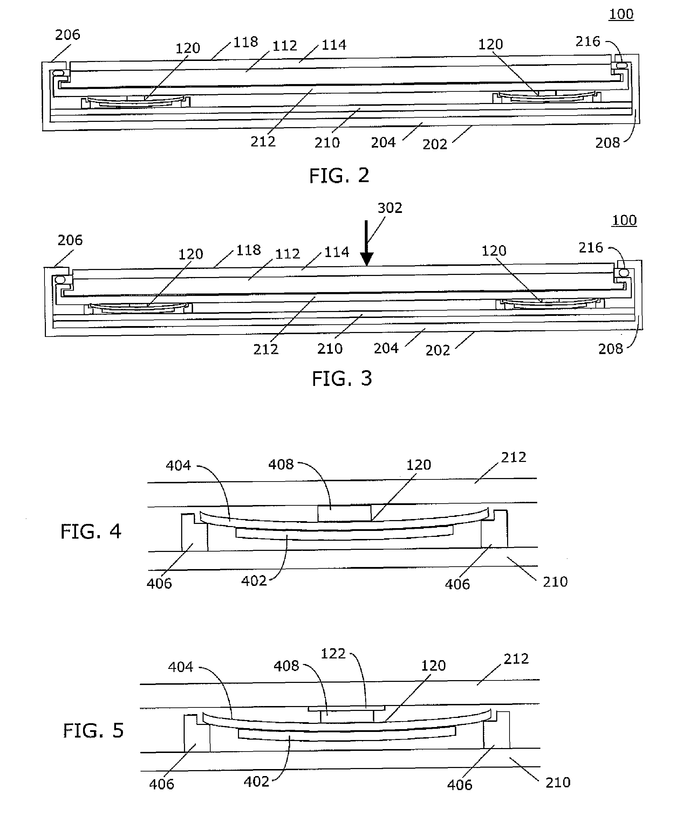

A sectional side view of a portable electronic device 100 with piezoelectric ("piezo") actuators 120 is shown in FIG. 2. The cross section is taken through the centers of the actuators 120. The portable electronic device 100 includes a housing 202 that encloses components such as shown in FIG. 1. The housing 202 may include a back 204 and a frame 206 that houses the touch-sensitive display 118. Sidewalls 208 extend between the back 204 and the frame 206. A base 210 extends between the sidewalls 208, generally parallel to the back 204, and supports the actuators 120. The display 112 and the overlay 114 are supported on a support tray 212 of suitable material, such as magnesium. Spacers 216 may be located between the support tray 212 and the frame 206. The spacers 216 may advantageously be flexible and may also be compliant or compressible, and may comprise gel pads, spring elements such as leaf springs, foam, and so forth.

The touch-sensitive display 118 is moveable and depressible with respect to the housing 202. A force 302 applied to the touch-sensitive display 118 moves, or depresses, the touch-sensitive display 118 toward the base 210, and when sufficient force is applied, the actuator 120 is depressed or actuated as shown in FIG. 3. The touch-sensitive display 118 may also pivot within the housing to depress the actuator 120. The actuators 120 may be actuated by pressing anywhere on the touch-sensitive display 118. The processor 102 receives a signal when the actuator 120 is depressed or actuated.

A sectional side view of a piezo actuator 120 is shown in FIG. 4. The actuator 120 may comprise one or more piezo devices or elements 402. The cross-section of FIG. 4 is taken through the center of one of the piezo actuators 120 utilized in this example. The piezo actuator 120 is shown disposed between the base 210 and the touch-sensitive display 118. The piezo actuator 120 includes a piezoelectric element 402, such as a piezoelectric ceramic disk, fastened to a substrate 404, for example, by adhesive, lamination, laser welding, and/or by other suitable fastening method or device. The piezoelectric material may be lead zirconate titanate or any other suitable material. Although the piezo element 402 is a ceramic disk in this example, the piezoelectric material may have any suitable shape and geometrical features, for example a non-constant thickness, chosen to meet desired specifications.

The substrate 404, which may also be referred to as a shim, may be comprised of a metal such as nickel or any other suitable material such as, for example, stainless steel, brass, and so forth. The substrate 404 bends when the piezo element 402 contracts diametrically, as a result of build up of charge at the piezo element 402 or in response to a force, such as an external force applied to the touch-sensitive display 118.

The substrate 404 and piezo element 402 may be suspended or disposed on a support 406 such as a ring-shaped frame for supporting the piezo element 402 while permitting flexing of the piezo actuator 120 as shown in FIG. 4. The supports 406 may be disposed on the base 210 or may be part of or integrated with the base 210, which may be a printed circuit board. Optionally, the substrate 404 may rest on the base 210, and each actuator 120 may be disposed, suspended, or preloaded in an opening in the base 210. The actuator 120 is not fastened to the support 406 or the base 210 in these embodiments. The actuator 120 may optionally be fastened to the support 406 through any suitable method, such as adhesive or other bonding methods.

A pad 408 may be disposed between the piezo actuator 120 and the touch-sensitive display 118. The pad 408 in the present example is a compressible element that may provide at least minimal shock-absorbing or buffering protection and may comprise suitable material, such as a hard rubber, silicone, and/or polyester, and/or may comprise other materials such as polycarbonate. The pad 408 may provide a bumper or cushion for the piezo actuator 120 as well as facilitate actuation of the piezo actuator 120 and/or one or more force sensors 122 that may be disposed between the piezo actuators 120 and the touch-sensitive display 118. The pad 408 does not substantially dampen the force applied to or on the touch-sensitive display 118. The pad 408 is advantageously aligned with a force sensor 122. When the touch-sensitive display 118 is depressed, the force sensor 122 generates a force signal that is received and interpreted by the processor 102. The pads 408 facilitate the focus of forces exerted on the touch-sensitive display 118 onto the force sensors 122. The pads 408 transfer forces between the touch-sensitive display 118 and the actuators 120, whether the force sensors 122 are above or below the pads 408. The pads 408 are advantageously flexible and resilient, and facilitate provision of tactile feedback from the actuators 120 to the touch-sensitive display 118.

An optional force sensor 122 may be disposed between the piezo actuator 120 and the touch-sensitive display 118 as shown in FIG. 5. The force sensor 122 may be disposed between the touch-sensitive display 118 and the pad 408 or between the pad and the piezo actuator 120, to name a few examples. The force sensors 122 may be force-sensitive resistors, strain gauges, piezoelectric or piezoresistive devices, pressure sensors, or other suitable devices. Force as utilized throughout the specification, including the claims, refers to force measurements, estimates, and/or calculations, such as pressure, deformation, stress, strain, force density, force-area relationships, thrust, torque, and other effects that include force or related quantities. A piezoelectric device, which may be the piezo element 402, may be utilized as a force sensor.

A touch threshold is a value associated with a touch, such that when a value of a touch meets the touch threshold, a function is performed. A value meets a threshold when the value is at or beyond the threshold. A touch threshold value may be a value of a characteristic of a touch, for example, a force imparted by a touch on the touch-sensitive display, a displacement distance of at least a part of the touch-sensitive display 118, an area of contact of a touch, a time duration of a touch, and so forth, or any combination thereof. For example, when the touch threshold is a force value, that force threshold may reflect, for example, the force of a touch that actuates the actuator(s) 120 or a force measured or detected by a force sensor 122, which force may be interpreted by the processor 102 to meet the touch threshold. A touch threshold may be a single unit-less value that is a combination of two or more values related to the touch, e.g., duration and force. Multiple touch thresholds may be applicable for a touch, and different values of touch thresholds may be associated with different functions or input. For example, a force below a first force threshold may result in panning an image, a force above the first force threshold and below a second force threshold may result in zooming on the image, and a force above the second force threshold may result in displaying the image in a default or initial state. Different touch thresholds may be associated with different touch characteristics. For example, a touch that has a contact area between a first size and a second size may trigger highlighting of a selection option; when the touch duration meets a time threshold, a different selection option is highlighted; and when the force of the touch exceeds a force threshold, tactile feedback is provided and the currently highlighted selection option is selected. Other combinations are possible.

Touch thresholds are modifiable and may be based on the values of any number of parameters, as described below. Baseline or default touch thresholds are advantageously established, e.g., based on the application, whether or not a keyboard 604 is utilized, and so forth. Baseline thresholds may be established, for example, to reduce inadvertent input, e.g., selections resulting when the portable electronic device 100 is carried in a pocket or bag, for instance. For example, a touch threshold related to contact area for a touch may be set to disregard touches individually or cumulatively larger than a given area that may suggest normal operation is not occurring. A threshold related to a number of simultaneous touches on the touch-sensitive display, e.g. five or more, may be considered too many for normal operation, and such touches may be disregarded by the device 100. The portable electronic device 100 may include a training sequence during which the user is prompted to apply various touches to the touch-sensitive display 118, for example, entering characters via virtual keys 604, typing quickly, drawing shapes, and other touch actions that provide training information. The device 100 collects data from the touches to establish at least one baseline for one or more touch thresholds. A touch threshold may be decreased, e.g., reduced force, shorter duration, smaller contact area, and so forth, such that the threshold is easier to meet. A touch threshold may be increased, e.g., greater force, longer duration, larger contact area, and so forth, such that the threshold is more difficult to meet.

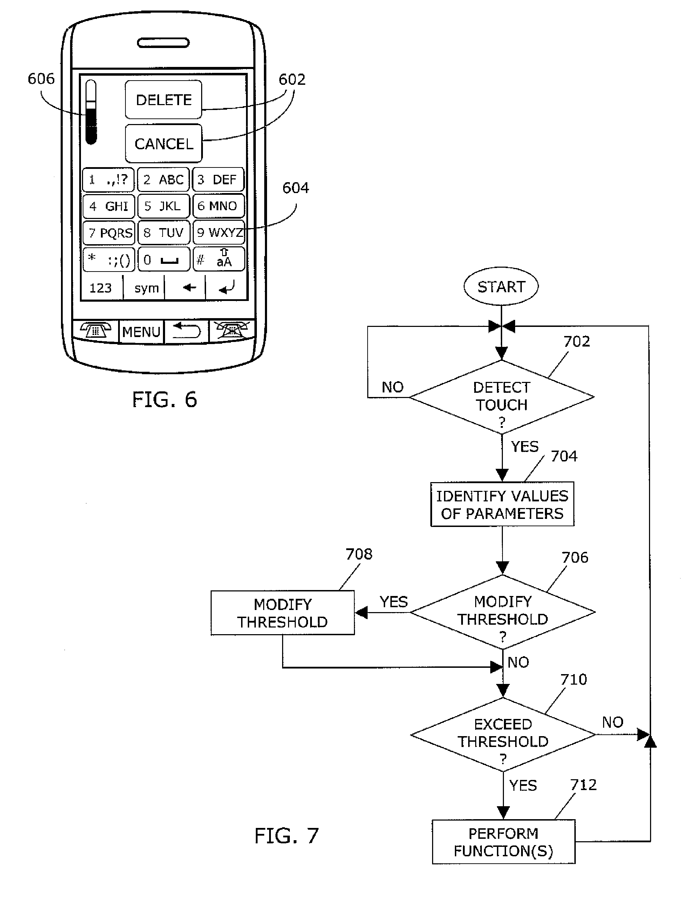

A front view of a portable electronic device 100 having a touch-sensitive display 118 is shown in FIG. 6. A touch detected on the touch-sensitive display 118 may initiate or trigger one or more functions. The function performed may be, for example, selection or input of information or a function, such as information or a function associated with a location of a touch, tactile feedback provided by the actuators 120, and so forth. Selection options may include, for example, displayed or virtual keys of a keyboard 602 for entry of characters; selection boxes or windows 602, e.g., "cancel," "delete," or "unlock"; function buttons, such as play or stop on a music player; and so forth. For example, a touch that does not meet a touch threshold may cause a selection option to be highlighted, such as a displayed button 602 or key 604, whereas a touch that meets the touch threshold may result in selection or input of that selection option.

Another example of a function is provision of tactile feedback, such as a vibration, one or more pulses, feedback that mimics depression and/or release of a physical key, and so forth. Other functions include, for example, opening an application, sending a message, powering down, closing an application, panning, zooming, and so forth. Other functions are known in the art.

Alternatively, the initial application of a touch need not trigger a function. Optionally, no function may be performed when a touch is associated with a non-active location on the touch-sensitive display 118, e.g., a location not associated with a selection option. The touch threshold is effectively infinite in such locations because no touch triggers the performance of a function.

Optionally, visible or audible feedback may be provided to illustrate the relationship between current touch values, such as force, contact area, duration, and so forth, and one or more touch thresholds. For example, when a touch is below a touch threshold, a virtual object may change color and when the touch exceeds the touch threshold, a tone may be produced indicating successful trigger of the function associated with the selection option. Optionally, a level indicator 606, such as shown in FIG. 6, may illustrate the current value for a touch in shaded format, as well as the touch threshold that is illustrated with a line.

Optionally, the actuators 120 may provide additional resistance to a force imparted on the touch-sensitive display 118. In this situation, a user perceives tactile feedback in the form of an opposing force to a touch imparted on the touch-sensitive display 118, which may cause the user to press harder to make selections. Such a more forceful press may be desirable, for example, when selecting an emergency call option or the user may simply prefer a more resistive feel to the virtual buttons 602 or keys 604.

A flowchart illustrating a method of modifying a touch threshold is shown in FIG. 7. The method may be carried out by software executed, for example, by the processor 102. Coding of software for carrying out such a method is within the scope of a person of ordinary skill in the art given the present description. The method may contain additional or fewer processes than shown and/or described.

When a touch is detected at 702, values of one or more various parameters are identified at 704. Optionally, the parameters relevant to a touch threshold and/or relevant to modifying a touch threshold may be identified, for example, when one or more touch thresholds may be based on multiple different parameters. The parameters may include, for example, touch parameters, function parameters, ambient parameters, and user parameters. Touch parameters reflect characteristics of a touch, for example, touch force, touch duration, contact area, touch rate, touch location, and so forth. Function parameters reflect attributes of a function performed by the portable electronic device 100, such as the type or history of a function. Ambient parameters reflect attributes of the environment in which the portable electronic device 100 is operating, such as current date, current time, ambient temperature, humidity, pressure, or light, acceleration/unstable movement of the device, and so forth. User parameters reflect the user's touch profile/preferences, typing habits and tendencies, historical data related to the user, and so forth.

A determination whether to modify one or more touch threshold is made at 706. Relevant touch thresholds are modified at 708. Parameters or characteristics of the touch as well as other variables may be utilized to modify a touch threshold, and tables or simple equations or formulas may be applied in the modification process. The values of one or more parameters may be evaluated to determine whether any of the touch thresholds are to be modified. The values of the parameters may be provided by various sensors and evaluated, for example, by the processor 102. Touch sensors of the touch-sensitive display and force sensors 122 may provide values for various parameters, such as touch parameters, e.g., contact area, touch rate, touch location, and touch force, as well as function or user parameters. Other sensors, such as an accelerometer, or data from a network, such as date, time, or temperature, may provide values for other parameters.

Modifying a touch threshold involves changing the value of one or more characteristics associated with the touch threshold. For example, when the threshold reflects a single characteristic of a touch, such as force, the touch threshold is a force threshold, and the associated force value is increased or decreased when the touch threshold is modified. Modifying the touch threshold may comprise modifying a threshold of other characteristics related to a touch, such as the duration of a touch, the number of touches, the touch rate, and the size of the contact area, and so forth. One or more characteristics of a touch may be combined to comprise a touch threshold, for example, force and time. The following are several examples of when and how one or more touch thresholds may be modified.

When the number of instances of inadvertent touches occurs during a period of time, the portable electronic device 100 is likely being carried in a pocket or bag, and the force threshold aspect of the touch threshold may be increased for a fixed period of time or until the inadvertent touches are not detected for a period of time. A touch may be considered inadvertent, for example, based on the contact area, number of simultaneous distinct touches on the touch sensitive display 118, duration of touch, and so forth. Touch entry may optionally be suspended until inadvertent touches are no longer detected. Use of a higher force threshold or suspension of touch entry in response to inadvertent touches may reduce power consumption and prevent unintended voice calls and text messaging.

The touch threshold may be modified based on the rate of detected touches, also referred to herein as the touch rate, e.g., how often touches occur or the number of touches in a period of time. For example, when the touch rate is high, the touch threshold may be decreased, to reduce the user's effort to trigger functions, such as when typing on a virtual keyboard 604. When the touch rate is low, the touch threshold may be increased, resulting in more deliberate touches to meet the threshold, such as when selecting the "DELETE" virtual button 602.

The touch thresholds may be modified based on location of the touch, e.g., different areas on the touch-sensitive display may have different touch thresholds. Different touch thresholds may be established for different locations on a touch-sensitive display 118, and for each different layout of displayed information. Locations associated with selection options may have lower touch thresholds, and locations not associated with selection options may have higher, up to infinite, touch thresholds. The center area of the displayed area of a selection option, such as the middle area of a button 602 or key 604, may have the lowest threshold, areas near the outer perimeter or margin of the active area of a selection option may have a slightly higher threshold, and areas outside the active area of a selection option may have the highest thresholds. A selection or active area is the area associated with a selection option, such that a touch detected at a location within the associated selection area results in selection of that selection option. Typically, the selection area is the same as the display area for a selection option, although selection areas may be larger, smaller, shifted, or skewed from the associated display area. The touch threshold information may be stored in a table, map, or equation for each different screen or layout. For example, a force threshold table may be assigned to a keyboard 604 layout for either or both landscape and portrait orientations. Layouts may be associated with each application or may be shared between multiple applications. Over time, location-based thresholds may provide the advantage of training a user to touch selection options more accurately, resulting in quicker data entry and reduced power consumption.

The contact area of the touch may be considered when modifying the touch threshold. For instance, the size of the contact area relative to a selection option, a previous touch, an absolute scale, and so forth, may be considered in modifying the touch thresholds. A smaller contact area may result in the touch threshold being decreased, for example, because a user may have smaller fingers and/or a lighter touch. A larger contact area may result in the touch threshold being increased, for example, because a user may have larger fingers and/or a heavier touch.

Touch thresholds may be modified based on a function parameter, such as the type or history of a function. For example, the touch threshold of selection option associated with an execution-type function, such as sending a message, deleting a contact, running a software application, and so forth, may be modified to increase the touch threshold, such that the touch imparted on the touch-sensitive display 118 to trigger performance of the function may be more deliberate or controlled. Simultaneously displayed selection options may have different thresholds, e.g., the "DELETE" box 602 may have a higher touch threshold than the "CANCEL" box 602. The touch threshold for non-execution-type functions, such as data entry, volume adjustment, scrolling, and so forth, may be modified to increase the touch threshold, such that the touch imparted on the touch-sensitive display 118 to trigger performance of the function may be less deliberate or controlled.

The touch threshold may be modified in response to history information for a function. The history of a function may include past information/data related to the function, such as how often the function is executed, in what relative order the function is executed with respect to other functions, and so forth. For example, a decreased touch threshold may be present for a space character immediately after a period is entered, and increased touch threshold may be present for a power switch for the portable electronic device 100 during a phone call.

The touch threshold may be modified based on one or more ambient parameters. For example, the portable electronic device 100 may be operated during travel, e.g., when a user is on a train, in an automobile, on a bicycle, jogging, in an elevator, and so forth. Such travel may result in rough, jarring, bouncy, and otherwise uneven conditions that may cause accurate input to the device 100 to be difficult. Such conditions may be detected by the accelerometer 136, and the touch threshold may be modified, e.g., increased, in response to the acceleration of the portable electronic device 100 in response to such conditions. When ambient light is low, for example, late on a workday, e.g., 10:00 PM to 5:00 AM, a user may be fatigued, and the touch threshold may be reduced. The touch threshold may be modified to adjust operation of the device 100 for the ambient temperature, e.g., over eighty degrees Fahrenheit, high relative humidity, e.g., over sixty percent to compensate for user or device 100 reaction to the ambient conditions.

Touch thresholds may be modified based on user parameters such as user history, user profile, and manual threshold settings. The user history may contain information such as a user's tendencies or habits when touching selection options, e.g., touching toward a corner or slide-typing, most frequently entered functions or words, and other parameters related to the history of one or more users of the portable electronic device 100. For example, when a user frequently deletes a "K" after entering an "L," the touch threshold may be modified to increase the touch threshold, e.g., duration, that triggers entry of a "K" after an "L" is input. A user profile may include parameter preferences entered into the portable electronic device 100 by the user, such as touch duration, touch/key rate, tap interval, hover period, swipe sensitivity, tactile feedback intensity, and so forth. Applications may provide for application-specific touch thresholds. The device may also provide a user with a manual setting or adjustment for one or more touch thresholds, for example, via an application interface or physical button. The manual settings may include current touch thresholds or maximum and the minimum values for the touch threshold.

The touch thresholds may be modified based on parameters that are independent of a detected touch, e.g., ambient parameters. Thus, the touch thresholds may be modified without detecting a touch. Nevertheless, touch threshold modification may be triggered by a detected touch to reduce unnecessary processing and power consumption that may result from threshold analysis and modification when touches are far apart or when many parameters change in a short period of time.

The parameters described are examples and do not limit the variety or number of parameters that may be utilized to modify touch thresholds. Touch thresholds may be repeatedly modified in response to change in any number, combination, and hierarchy of parameters. One or more parameters may be utilized to modify a single touch threshold.

One or more values of one or more parameters or characteristics of the touch are compared to the touch threshold at 710, e.g., a force value or contact area. The detected touch may be compared to more than one threshold at 710. When the one or more values related to the touch do not meet any touch threshold, the process continues at 702. When the one or more values meet or exceed one or more touch thresholds, one or more functions, such as those described above, are performed 712, and the process continues at 702. The detected touch may meet multiple touch thresholds and multiple functions may be performed. For example, a light touch on a "ALT" virtual key 604 highlights the "ALT" virtual key 604 when the touch meets a first touch threshold, and when the touch stays in the same location and is more forcefully applied until a second touch threshold is met, an alternate set of characters is displayed on the keyboard 604. Optionally, a third touch threshold may also be applied, and when the touch meets the third threshold in this example, an "ALT" lock may be engaged, wherein a lock indicator is displayed, and the alternate set of characters is displayed and characters from the set are entered until a subsequent touch or tap on the "ALT" key. Tactile feedback may also be provided when the second touch threshold is met, and alternatively when the third touch threshold is met.

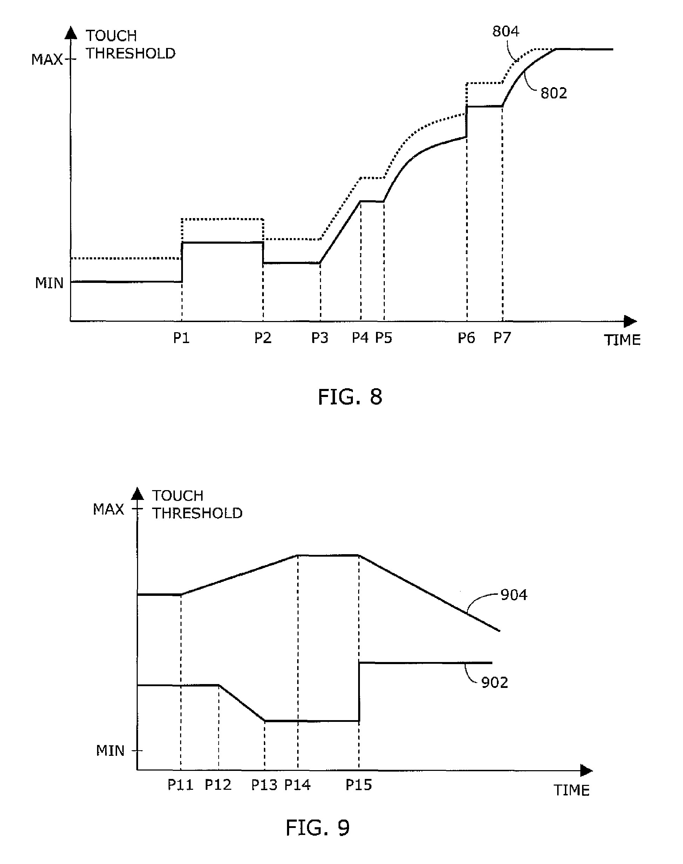

A graph illustrating various values of a touch threshold over time is shown in FIG. 8. The touch threshold 802 shown in the example of FIG. 8 varies in response to different parameters. The touch threshold 802 is shown at a minimum until the time when a change in parameter P1 is identified, resulting in the touch threshold 802 being modified by increasing the touch threshold. For example, the parameter P1 may be a function parameter.

The touch threshold 802 remains constant until parameter P2 causes the touch threshold 802 to be reduced or lowered. For example, the amount of ambient light may be parameter P2 resulting in a lower touch threshold. The touch threshold 802 remains constant until parameter P3 causes a generally linear increase in the touch threshold 802 over time. This increase may be caused by an ambient parameter, such as the time passing late in a day, e.g., at 10 PM. A parameter P4, such time of day reaching 6 AM, results in the touch threshold 802 becoming constant. Detection in a change in parameter P5 results in the modification of the touch threshold 802 in a non-linear fashion. For example, parameter P5 may be a decreasing touch rate over time. The touch threshold may be modified due to a detected change in parameter P6, for example, acceleration of the portable electronic device 100. The touch threshold 802 may be modified in a non-linear manner over time due to parameter P7 until the maximum touch threshold is reached. Parameter P7 may be, for example, a user profile whereby the touch threshold 802 increases over time when no touches are detected until the maximum touch threshold 802 is reached.

Optionally, an alternate touch threshold 804 may be engaged, as illustrated by a dotted line. The alternate touch threshold may be engaged by a user manually setting the touch threshold, a user preference, or the completion of a training sequence is also illustrated in FIG. 8. The alternate touch threshold 804 may instead be a reduced touch threshold. The alternate touch threshold effectively changes the touch threshold across all touch conditions, either increasing or reducing all touch thresholds or threshold modifications.

A graph illustrating various values of two touch thresholds over time is shown in the example of FIG. 9. The lower touch threshold 902 in this example is a touch threshold that results in highlighting a selection option when a detected touch meets the lower touch threshold 902. The upper touch threshold 904 in this example is a touch threshold that results in input of a selection option and/or provision of tactile feedback when a detected touch meets the upper touch threshold 904. Both touch thresholds 902, 904 are modifiable. The terms "lower" and "upper" are utilized for reference only within FIG. 9 and are not otherwise limiting. The lower touch threshold 902 and the upper touch threshold 904 may be modified interdependently or individually.

When a change in parameter P11 is identified, the upper touch threshold 904 is modified by linearly increasing the upper touch threshold 904 over time, although the lower touch threshold remains unchanged. For example, the parameter P11 may be a combination of ambient parameters changing over time. Parameter P12 causes the lower touch threshold 902 to be modified by linearly decreasing the lower touch threshold 902 over time until detection of change in parameter P13. Neither of the parameters P12 and P13 affects the upper touch threshold 904. Parameters P12 and P13 may be, for example, the start and end of a manual user adjustment, respectively. Parameter P14 is the stabilization of parameter P11, which results in the upper touch threshold 904 becoming a constant value, although the lower touch threshold 902 is unaffected by parameter P14. Parameter P15 is identified with characteristics sufficient to modify the lower touch threshold 902 by increasing the threshold and the upper touch threshold 904 modified. Parameter P15 may be, for example, a combination of a function parameter and a touch parameter. The function parameter, such as the touch threshold associated with drafting an email message, sets the lower touch threshold 902 for alphanumeric input, and the upper touch threshold 904 generally decreases as the force of repeated touches decreases.

Although specific parameters are described in the examples of FIG. 8 and FIG. 9, the touch threshold may be modified at any time based on one or more parameter or parameters, e.g., a touch parameter, a function parameter, an ambient parameter, a user parameter, and so forth. Although the examples illustrate one threshold and two touch thresholds, any number of touch thresholds may be utilized, some or all of which may be modifiable.

Although the above description utilizes the example of a touch-sensitive display, the method and embodiments may be applied to other touch-sensitive devices that do not include a display, such as a trackball, trackpad, touchpad, optical trackpad or touchpad, and so forth. The method may also be applied to the physical keys of a keyboard or other keys, buttons, switches, actuators, and other control devices for which touch thresholds may be utilized. The method may be applied to moveable or non-moveable (e.g., fixed with respect to a housing) touch-sensitive displays, touch-sensitive devices with or without tactile feedback, and touch-sensitive devices with or without force sensors.

The present disclosure describes a method and apparatus that reduces the occurrence of inadvertent touches causing functions to be performed, such as entering characters, calling a contact, or sending text messages, which may needlessly drain the battery of a portable electronic device. The use of multiple thresholds provides a mechanism by which multiple different functions may be triggered by touch alone. Use of thresholds may help to train a user to more quickly find the selection area for a selection option, resulting, for example, in faster typing on a virtual keyboard.

A method comprises detecting a touch on a touch-sensitive device and identifying a value of at least one parameter of the touch. A touch threshold is modified based on the value of the at least one parameter, yielding a modified touch threshold. A first function is performed when the touch meets the modified touch threshold.

An electronic device comprises a touch-sensitive device and a processor configured to: detect a touch on the touch-sensitive device; identify a value of at least one parameter of the touch; modify a touch threshold based on the at least one parameter to yield a modified touch threshold; perform a first function when the touch meets the modified touch threshold.

A method comprises identifying a value of at least one parameter of a portable electronic device, modifying a touch threshold based on the at least one parameter, yielding a modified touch threshold, and detecting a touch on a touch-sensitive device. A function is performed when the touch meets the modified touch threshold.

The present disclosure may be embodied in other specific forms without departing from its spirit or essential characteristics. The described embodiments are to be considered in all respects only as illustrative and not restrictive. The scope of the disclosure is, therefore, indicated by the appended claims rather than by the foregoing description. All changes that come within the meaning and range of equivalency of the claims are to be embraced within their scope.

## Claims

1. A method comprising:
identifying a value of at least one parameter of a portable electronic device;
modifying a touch threshold based on the at least one parameter, yielding a modified touch threshold;
detecting a touch on a touch-sensitive device;
performing a function when the touch meets the modified touch threshold.

2. The method of claim 1, wherein the value of the at least one parameter is determined from a touch detected by the touch-sensitive device.

3. The method of claim 1, wherein performing the function comprises providing tactile feedback.

4. The method of claim 1, wherein the at least one parameter comprises at least one of a touch parameter, a function parameter, an ambient parameter, and a user parameter.

5. The method of claim 1, wherein a force value is associated with the touch threshold.

6. The method of claim 5, wherein modifying the touch threshold comprises increasing the force value associated with the touch threshold.

7. The method of claim 1, wherein modifying the touch threshold occurs after detecting the touch.

8. A computer-readable medium having computer-readable code executable by at least one processor of a portable electronic device to perform the method of claim 1.

9. An electronic device comprising:
a touch-sensitive device;
a processor configured to:
identify a value of at least one parameter of the portable electronic device;
modify a touch threshold based on the at least one parameter to yield a modified touch threshold;
detect a touch on the touch-sensitive device;
perform a first function when the touch meets the modified touch threshold.

10. The electronic device of claim 9, further comprising an actuator configured to provide tactile feedback when the touch meets the modified touch threshold.

11. The electronic device of claim 9, wherein the processor is further configured to modify a second touch threshold associated with a second function that is performed when the touch meets the second touch threshold.

12. The electronic device of claim 9, further comprising a force sensor configured to provide a force value related to the touch.

13. The electronic device of claim 9, wherein the touch-sensitive device is disposed in a housing and is moveable with respect to the housing.

14. The electronic device of claim 13, wherein the touch-sensitive device comprises a touch-sensitive display.

15. A method comprising:
detecting a touch on a touch-sensitive device;
identifying a value of at least one parameter of the touch;
modifying a touch threshold based on the value of the at least one parameter, yielding a modified touch threshold;
performing a function when the value meets the modified touch threshold.

## Amended claims

### Amended claims in accordance with Rule 137(2) EPC.

**1.** A method comprising:
identifying a value of at least one parameter of a portable electronic device (100);
modifying a touch threshold, wherein the touch threshold is a force value,
based on the at least one parameter, yielding a modified touch threshold;
detecting a touch on a touch-sensitive device (118);
performing a function when the touch meets the modified touch threshold.

**2.** The method of claim 1, wherein the value of the at least one parameter is determined from a touch detected by the touch-sensitive device (118).

**3.** The method of claim 1, wherein performing the function comprises providing tactile feedback.

**4.** The method of claim 1, wherein the at least one parameter comprises at least one of a touch parameter, a function parameter, an ambient parameter, and a user parameter.

**5.** The method of claim 1, wherein the force value is representative of a force imparted by the touch on the touch-sensitive device (118).

**6.** The method of claim 1, wherein modifying the touch threshold comprises increasing the force value associated with the touch threshold.

**7.** The method of claim 1, wherein modifying the touch threshold occurs after detecting the touch.

**8.** A computer-readable medium having computer-readable code executable by at least one processor (102) of a portable electronic device to perform the method of any of claims 1 to 7.

**9.** An electronic device (100) comprising:
a touch-sensitive device (118);
a processor (102) configured to:
identify a value of at least one parameter of the portable electronic device (100);
modify a touch threshold, wherein the touch threshold is a force value, based on the at least one parameter to yield a modified touch threshold;
detect a touch on the touch-sensitive device (118);
perform a first function when the touch meets the modified touch threshold.

**10.** The electronic device (100) of claim 9, further comprising an actuator (120) configured to provide tactile feedback when the touch meets the modified touch threshold.

**11.** The electronic device (100) of claim 9, wherein the processor (102) is further configured to modify a second touch threshold associated with a second function that is performed when the touch meets the second touch threshold.

**12.** The electronic device (100) of claim 9, further comprising a force sensor (122) configured to provide a force value related to the touch.

**13.** The electronic device (100) of claim 9, wherein the touch-sensitive device (118) is disposed in a housing (202) and is moveable with respect to the housing (202).

**14.** The electronic device (100) of claim 13, wherein the touch-sensitive device (118) comprises a touch-sensitive display.

**15.** A method comprising:
detecting a touch on a touch-sensitive device (118);
identifying a value of at least one parameter of the touch;
modifying a touch threshold, wherein the touch threshold is a force value, based on the value of the at least one parameter, yielding a modified touch threshold;
performing a function when the value meets the modified touch threshold.
